# FASCICULE DE BREVET EUROPEEN

(11) **EP 0 531 215 B1**
(45) Date de publication et mention de la délivrance du brevet: **27.12.1995**
(21) Numéro de dépôt: 92402409.4
(22) Date de dépôt: 03.09.1992
(51) Int. Cl.: G02B 6/42, H01L 31/0232, G02B 6/12

(54) **Dispositif optoélectronique à guide optique et à photodétecteur intégrés**
Opto-elektronisches Bauteil mit Wellenleiter und integriertem Photodetektor
Optoelectronic device with lightguide and integrated photo-detector

(30) Priorité: 06.09.1991 FR 9111044
(43) Date de publication de la demande: 10.03.1993
(73) Titulaire: FRANCE TELECOM, 75015 Paris (FR)
(72) Inventeur: Bruno, Adrien, F-91120 Palaiseau (FR); Menigaux, Louis, F-91440 Bures Sur Yvette (FR)
(74) Mandataire: Signore, Robert

(56) Documents cités:
- EP-A- 0 278 408
- EP-A- 0 361 159
- FR-A- 2 655 775
- GB-A- 2 220 083
- PATENT ABSTRACTS OF JAPAN vol. 8, no. 115 (E-247)29 Mai 1984 & JP-A-59 029 472

## Description

### Domaine technique

La présente invention a pour objet un dispositif optoélectronique à guide optique et à photodétecteur intégrés et un procédé de réalisation d'un tel dispositif.

Elle trouve une application en optoélectronique, et notamment en télécommunications optiques où le dispositif de l'invention peut constituer le récepteur optique d'une liaison (circuit de réception hétérodyne ou de détection directe, ...)

Le dispositif de l'invention peut être utilisé également dans des interconnexions optiques entre "puces" électroniques rapides à haut degré d'intégration (entre ordinateurs, ou à l'intérieur d'ordinateurs). Un tel dispositif peut apparaître en métrologie dans, par exemple, des capteurs optiques intégrés.

### Etat de la technique

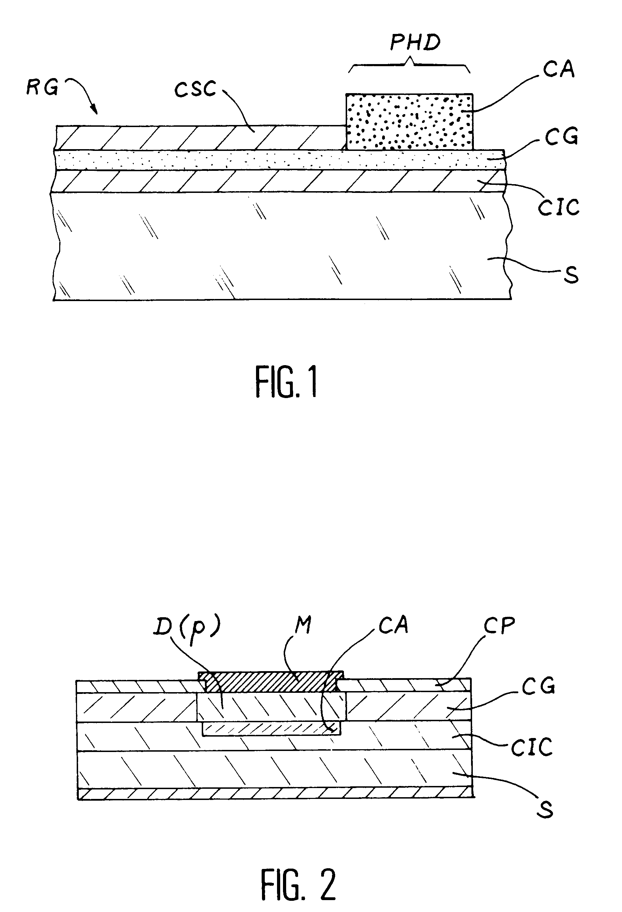

Un dispositif optoélectronique à guide optique et à photodétecteur intégrés connu est représenté sur la figure 1. Ce dispositif comprend, sur un substrat semiconducteur S, successivement : une première couche dite couche inférieure de confinement CIC, en un premier matériau ayant un premier indice, une deuxième couche dite couche guide CG en un deuxième matériau ayant un deuxième indice supérieur au premier, une troisième couche dite couche supérieure de confinement CSC en un troisième matériau ayant un troisième indice inférieur au second. Ces couches sont gravées latéralement pour constituer un ruban de guidage RG.

Cette structure se complète par un photodétecteur PHD placé au-dessus de la couche guide. L'onde qui se propage dans la couche guide CG atteint la couche absorbante constitutive du detecteur et est absorbée par un mécanisme d'onde évanescente.

Un dispositif guide-détecteur intégré à couplage par onde évanescente est décrit, par exemple, dans l'article de R.J. DERI et al., intitulé : "Integrated Waveguide/Photodiode with Vertical impédance Matching", publié dans "Proceedings of the 1989 IEDM", Washington D.C., Décembre 1989.

Un autre dispositif connu à guide et à photodétecteur intégrés est représenté sur la figure 2. Il comprend un substrat S, une couche inférieure de confinement CIC dopée n, une couche absorbante CA, une couche guide CG avec une partie diffusée p, référencée D(p), une couche de passivation CP et une couche métallique M.

La disposition est donc inversée par rapport à celle de la figure 1, en ce sens que la couche absorbante CA est disposée sous la couche guide CG et non au-dessus.

Un tel dispositif est décrit dans le document EP-A-0 278 408.

Bien que donnant satisfaction à certains égards, tous ces dispositifs présentent des inconvénients. En particulier, ils nécessitent une grande longueur de photodétecteur si l'on veut obtenir une absorption totale du rayonnement optique. Or, ceci va à l'encontre de l'un des buts recherchés qui est de diminuer le temps de réponse du dispositif, ce qui impliquerait plutôt une réduction de la surface du détecteur.

Dans l'article de J.C. BOWERS et al., intitulé "Millimeter-Waveguide Mounted InGaAs Photodetectors", publié dans la revue Electronics Letters, 5 Juin 1986, vol. 22, n° 12, p. 633, il est indiqué que, pour avoir une largeur de bande à 3dB supérieure à 50 GHz, la surface de la diode doit être inférieure à 200 »m².

L'évolution des dispositifs intégrés ces dernières années montre bien l'importance attachée à la réduction de la surface de la diode par diminution de la longueur d'absorption. Le tableau présenté par M. ERMAN et al. dans leur article intitulé "Optical Circuits and Integrated Detectors" publié dans la revue IEE Proceedings-J, vol. 138, n° 2, Avril 1991, p. 101, en donne un aperçu. On peut y voir que les caractéristiques des systèmes intégrés tendent vers un rendement de couplage voisin de 100% et une longueur d'absorption la plus courte possible.

Quant à la structure de la figure 2, elle présente avant tout l'avantage d'être planaire car, en renversant la disposition de la couche absorbante, elle permet d'éviter le mésa constitué par le photodétecteur placé au-dessus du guide. Mais cette variante conduit à un procédé de réalisation très complexe.

En effet, la couche absorbante CA doit être déposée par reprise d'épitaxie localisée à l'intérieur d'une partie gravée dans une couche dopée n (la couche CIC). La couche guide CG est ensuite rajoutée par reprise d'épitaxie. Une diffusion localisée D(p) dans la zone de l'absorbant doit ensuite être réalisée dans la couche guide CG en dopant p cette partie du guide. Une diode détectrice PIN est ainsi obtenue où I représente la zone intrinsèque, c'est-à-dire la couche absorbante CA, P la zone diffusée D(p) et N la couche dopée n CIC sous la couche guide CG.

Ce procédé est donc complexe. En outre, le dopage p induit des pertes d'énergie lumineuse par les porteurs de charge. Le dispositif souffre donc d'une réduction de rendement quantique.

### Exposé de l'invention

La présente invention a justement pour but de remédier à ces inconvénients. A cette fin, elle a pour objet un dispositif tel que defini à la revendication 1. Ainsi, la présente invention renonce à la complication technologique des dispositifs de la figure 2 pour en revenir à un dispositif à mésa du genre de celui de la figure 1 ; mais elle perfectionne ces dispositifs en prévoyant un moyen apte à augmenter l'absorption dans la couche absorbante ce qui permet de réduire la longueur du photodétecteur.

Ce moyen consiste à dégager la partie inférieure de la couche guide CG pour la mettre à l'air. L'indice de l'air étant faible par rapport à l'indice des matériaux généralement utilisés pour constituer les guides, une désadaptation d'indice importante est ainsi créée, qui a pour effet de "repousser" la lumière vers la couche absorbante et d'augmenter l'efficacité du photodétecteur.

Le dispositif obtenu est par ailleurs très simple à réaliser, puisqu'il ne nécessite qu'une seule opération d'épitaxie. Par ailleurs, les performances électriques et optiques sont excellentes : un rendement quantique maximal de 100% est obtenu et, avec un guide d'épaisseur 0,65 »m, la longueur du photodétecteur peut être réduite d'un facteur 2.

La présente invention a également pour objet un procédé de réalisation tel que défini à la revendication 5.

### Brève description des dessins

- la figure 1, déjà décrite, représente schématiquement un dispositif à guide optique et à photodétecteur intégrés selon l'art antérieur ;
- la figure 2, déjà décrite, représente une variante inversée d'un tel dispositif selon l'art antérieur ;
- la figure 3 montre, en coupe, le résultat d'une simulation de la distribution d'intensité d'un faisceau optique dans un dispositif de structure connue ;
- la figure 4 montre une simulation semblable dans un dispositif conforme à l'invention ;
- les figures 5a, 5b, 5c, 5d, 5e illustrent différentes étapes du procédé de réalisation de l'invention.

### Exposé détaillé d'un mode de réalisation

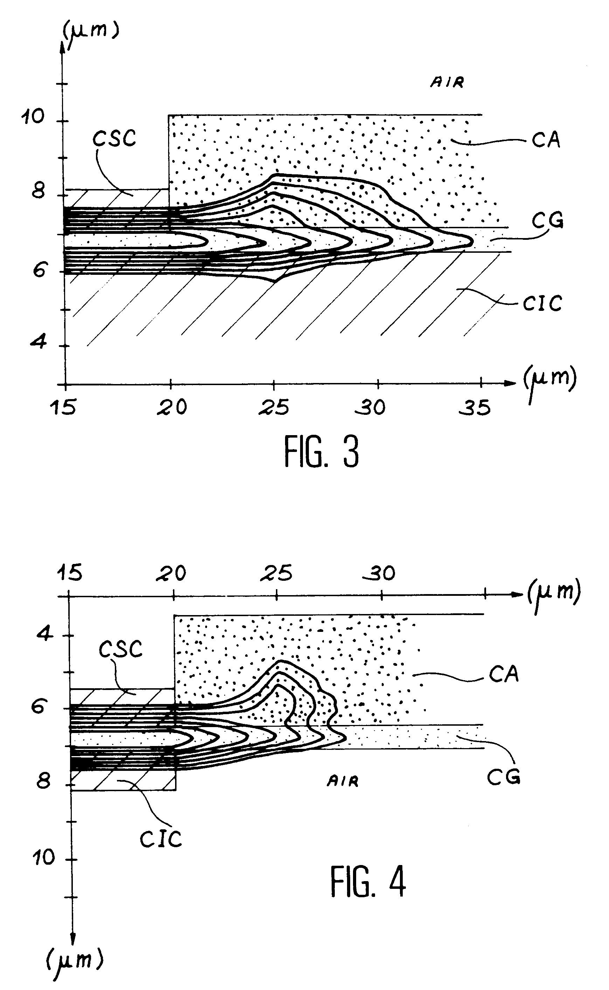

Une étude théorique et expérimentale a permis aux inventeurs de montrer l'efficacité d'une couche d'air au contact avec une couche guide dans un dispositif intégré. Les figures 3 et 4 illustrent les résultats de cette étude. Elles représentent, en coupe, la distribution de l'intensité du faisceau lumineux. Il s'agit de simulations optiques obtenues par la méthode dite BPM pour "Beam Propagation Method".

Ces simulations permettent de comparer l'absorption dans une structure classique (fig. 3) et dans une structure selon l'invention (fig. 4). Pour la simulation, les inventeurs ont considéré une longueur d'onde de 1,52 »m pour un faisceau qui se propage de la gauche vers la droite. Le passage d'une courbe à l'autre correspond à une atténuation de l'intensité du faisceau de 3 dB (c'est-à-dire d'un facteur 2).

La géométrie choisie pour la simulation correspond à une structure de guidage (partie gauche) à deux couches de confinement (couche inférieure de confinement CIC et couche supérieure de confinement CSC) en InP (indice 3,17) et à une couche guide CG en GaInAsP (bande interdite à 1,3 »m, indice 3,38). Les épaisseurs des couches sont indiquées sur l'échelle verticale en micromètres : soit 1 »m pour les couches de confinement, 0,65 »m pour la couche guide CG et 2 »m pour la couche absorbante CA.

Dans le cas de la figure 3, l'air n'intervient pas dans l'absorption. La longueur d'absorption est de 15 »m pour une atténuation de 21 dB (≃ 99%).

Dans le cas de la figure 4, l'air en contact avec la couche guide CG intervient en déplaçant vers la couche absorbante le mode optique, ce qui permet de réduire d'un facteur 2 la longueur d'absorption (8 »m pour une même atténuation de 21 dB).

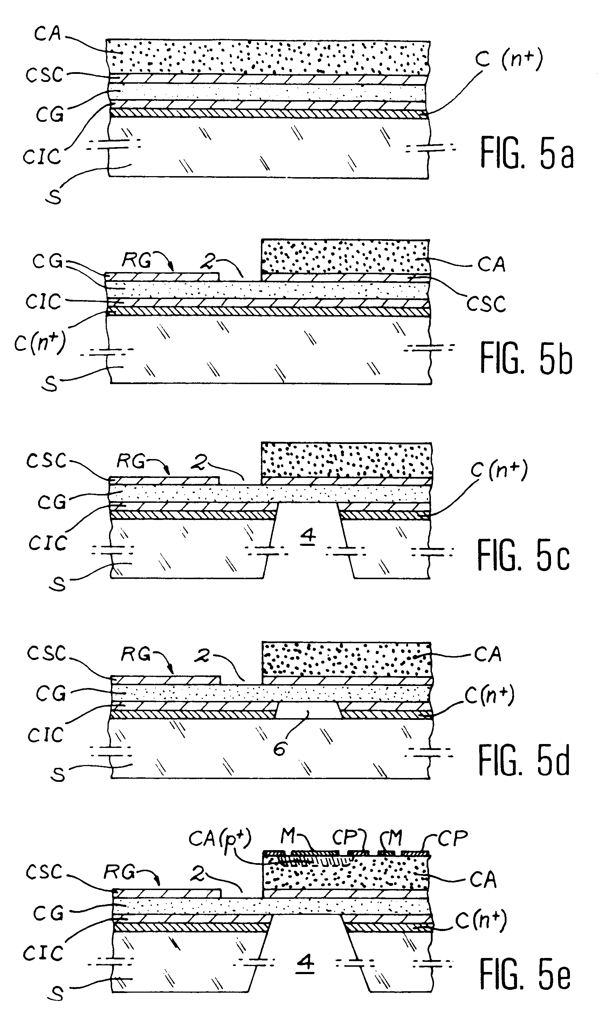

Les figures 5a à 5e illustrent différentes étapes d'un procédé de réalisation d'un dispositif conforme à l'invention.

Le procédé comprend schématiquement quatre phases :
a) sur un substrat S, dont la surface est préalablement dopée n+ (couche C(n+)), on dépose par épitaxie une couche inférieure de confinement CIC, une couche guide CG, une couche supérieure de confinement CSC et une couche absorbante CA, (figure 5a),
b) on grave latéralement les couches de confinement et la couche guide pour constituer un ruban de guidage RG et on grave la couche absorbante CA pour lui donner la forme d'un mésa en bout de structure de guidage, (figure 5b). On peut également graver la couche supérieure de confinement CSC devant le mésa, sur un certain intervalle 2 d'environ 10 »m. Cet intervalle 2 permet d'éviter l'absorption dès l'entrée dans le matériau absorbant et donc d'éloigner le détecteur du bord du mésa. Dans cet intervalle 2, le guide CG est au contact de l'air par sa face supérieure, ce qui "repousse" l'onde optique en profondeur grâce au faible indice de l'air (relativement au matériau du guide qui est généralement en GaInAsP). Le détecteur, c'est-à-dire la fenêtre de diffusion, peut être écarté du bord du mésa d'environ 3 »m sans perte d'absorption au passage dans la zone absorbante.
c) on retire localement la couche inférieure de confinement CIC sous le mésa pour mettre la surface inférieure de la couche guide CG en contact avec l'air (fig. 5c ou 5d),
d) on réalise, sur le mésa de la couche absorbante, un détecteur, soit de type MSM, soit de type PIN, soit de tout autre type connu. On peut former par exemple une zone dopée p+ (CA(p+), par exemple à l'aide de zinc, une électrode de contact M, ainsi que diverses couches de passivation CP (fig. 5e). L'étape d'épitaxie a) peut s'effectuer par toute technique connue : dépôt en phase vapeur aux organométalliques (MOCVD), épitaxie par jet moléculaire (EJM), etc...

Pour mettre la surface inférieure de la couche guide en contact avec l'air sous le mésa absorbant, deux variantes sont possibles :
- on réalise un trou 4 dans le substrat jusqu'à la couche inférieure de confinement CIC, puis on effectue une attaque chimique sélective de la couche inférieure de confinement CIC sans attaquer la couche guide CG (fig. 5c),
- on laisse le substrat mais on forme une poche d'air 6 (Fig. 5d). Pour cela, on attaque latéralement d'abord la couche dopée n+ C(n+) (généralement en GaInAsP) et ensuite la couche inférieure de confinement CIC (généralement en InP). Le contrôle de l'attaque par sous-gravure est en effet plus facile pour GaInAsP que pour InP. D'autres méthodes d'attaque sélective de ce type peuvent être utilisés notamment avec le système de GaAs/GaAlAs comme décrit par C.A. BEYLER et al. dans l'article intitulé "Small Dimension BRAGG Reflection Formed by Air-Isolated GaAs Layers" publié dans Electronics Letters, vol. 27, n° 7, p. 588, le 28 mars 1991. Le procédé consiste à modifier la structure cristalline par diffusion de silicium. Une fois réalisé le retrait de GaInAsP, soit par étalonnage de la solution de l'attaque latérale, soit par contrôle pendant l'attaque en utilisant des motifs de repérage, on peut passer à la dernière étape d'obtention du détecteur.

La figure 5e montre un dispositif optoélectronique terminé, dans la variante où l'on a dégagé la couche guide en perçant une ouverture dans le substrat (opération illustrée par l'ouverture 4).

## Revendications

1. Dispositif optoélectronique à guide optique et à photodétecteur intégrés comprenant, sur un même substrat semiconducteur (S): un guide optique constitué par une première couche dite couche inférieure de confinement (CIC), une deuxième couche dite couche guide (CG), une troisième couche dite couche supérieure de confinement (CSC), ces couches étant gravées latéralement pour constituer un ruban de guidage (RG); et un photodétecteur (PHD) en forme de mésa disposé au-dessus de la couche supérieure de confinement (CSC), ce photodétecteur comprenant notamment une quatrième couche dite couche absorbante (CA) apte à absorber un rayonnement provenant de la couche guide (CG) par évanescence à travers la couche supérieure de confinement (CSC), ce dispositif étant caractérisé par le fait que, dans la zone située sous le photodétecteur (PHD), au moins la couche inférieure de confinement (CIC) est enlevée, de telle sorte que la surface inférieure de la couche guide (CG) est au moins en partie, sous la couche absorbante (CA), en contact avec l'air.

2. Dispositif selon la revendication 1, caractérisé par le fait que le substrat (S) est creusé sous le photodétecteur (PHD) pour dégager la couche guide (CG) sous le photodétecteur (PHD).

3. Dispositif selon la revendication 1, caractérisé par le fait que le substrat (S) subsiste sous le photodétecteur (PHD) et qu'une poche d'air (6) est ménagée sous le photodétecteur (PHD) entre la couche guide (CG) et le substrat (S).

4. Dispositif selon l'une quelconque des revendications 1 à 3, caractérisé par le fait que la couche supérieure de confinement (CSC) est enlevée devant le photodétecteur sur une certaine longueur (2).

5. Procédé de réalisation d'un dispositif optoélectronique à guide optique et à photodétecteur intégrés selon la revendication 1, caractérisé par le fait qu'il comprend les opérations suivantes :
a) sur un substrat (S), on dépose par épitaxie une couche inférieure de confinement (CIC), une couche guide (CG), une couche supérieure de confinement (CSC) et une couche absorbante (CA),
b) on grave ensuite latéralement les couches de confinement et la couche guide pour constituer un ruban de guidage (RG) et on grave la couche absorbante (CA) pour lui donner la forme d'un mésa,
c) on retire ensuite localement la couche inférieure de confinement (CIC) sous au moins une partie du mésa (4, 6) pour mettre au moins une partie de la surface inférieure de la couche guide (CG) sous la couche absorbante en contact avec l'air, et
d) on forme enfin sur le mésa de la couche absorbante des moyens de contact.

6. Procédé selon la revendication 5, caractérisé par le fait que, pour mettre la surface inférieure de la couche guide (CG) en contact avec l'air sous la couche absorbante, on réalise un trou (4) dans le substrat (S) jusqu'à la couche inférieure de confinement (CIC), puis on effectue une attaque sélective de la couche inférieure de confinement (CIC) sans attaquer la couche guide (CG).

7. Procédé selon la revendication 5, caractérisé par le fait que, pour mettre la surface inférieure de la couche guide (CG) en contact avec l'air sous la couche absorbante (6), on attaque latéralement la couche inférieure de confinement (CIC) par sous gravure d'une couche superficielle du substrat.

8. Procédé selon la revendication 5, caractérisé par le fait que, lors de l'opération de gravure de la couche absorbante (CA), on grave également la couche supérieure de confinement (CSC) devant le mésa, sur un certain intervalle (2).

## Patentansprüche

1. Optoelektrische Vorrichtung mit integrierten optischem Leiter und Photodetektorzelle umfassend auf einem gemeinsamen Halbleitersubstrat (S): einen optischen Leiter, gebildet durch eine erste, als untere Einschließungsschicht (CIC) bezeichnete Schicht, eine zweite, als Leitschicht (CG) bezeichnete Schicht und eine dritte, als obere Einschließungsschicht (CSC) bezeichnete Schicht, wobei diese Schichten von der Seite her graviert sind, um ein Leitband (RG) zu bilden; und eine Photodetektorzelle (PHD) in Form eines über der oberen Einschließungsschicht (CSC) angeordneten Hochebene, wobei die Photodetektorzelle insbesondere eine vierte, als Absorbtionsschicht (CA) bezeichnete Schicht umfaßt, die eine Strahlung absorbieren kann, welche durch Verflüchtigung durch die obere Einschließungsschicht (CSC) hindurch von der Leitschicht (CG) ausgeht, wobei diese Vorrichtung
**dadurch gekennzeichnet** ist,
daß in der unter der Photodetektorzelle (PHD) gelegenen Zone mindestens die untere Einschließungsschicht (CIC) abgetragen ist, so daß die untere Oberfläche der Leitschicht (CG) unter der Absorbtionsschicht (CA) mindestens teilweise in Luftkontakt ist.

2. Vorrichtung gemäß Anspruch 1,
**dadurch gekennzeichnet,**
daß das Substrat (S) unter der Photodetektorzelle (PHD) ausgehöhlt ist, um die Leitschicht (CG) unter der Photodetektorzelle (PHD) freizulegen.

3. Vorrichtung gemäß Anspruch 1,
**dadurch gekennzeichnet,**
daß das Substrat (S) unter dem Photodetektor (PHD) erhalten bleibt, und daß ein Luftraum (6) unter der Photodetektorzelle (PHD) zwischen der Leitschicht (CG) und dem Substrat (S) ausgespart ist.

4. Vorrichtung gemäß einem der Ansprüche 1 bis 3,
**dadurch gekennzeichnet,**
daß die obere Einschließungsschicht (CSC) vor der Photodetektorzelle auf einer gewissen Länge (2) abgetragen ist.

5. Verfahren zur Herstellung einer optoelektronischen Vorrichtung mit integrierten optischem Leiter und Photodetektorzelle gemäß Anspruch 1,
**dadurch gekennzeichnet,**
daß es die folgenden Schritte umfaßt:
a) auf einem Substrat (S) wird durch Epitaxie eine untere Einschließungsschicht (CIC), eine Leitschicht (CG), eine obere Einschließungsschicht (CSC) und eine Absorbtionsschicht (CA) aufgetragen,
b) dann werden die Einschließungsschichten und die Leitschicht von der Seite her graviert, um ein Leitband (RG) zu bilden, und die Absorbtionsschicht (CA) wird graviert, um ihr die Form einer Hochebene zu geben,
c) dann wird die untere Einschließungsschicht (CIC) mindestens unter einem Abschnitt der Hochebene (4, 6) örtlich entfernt, um mindestens einen Abschnitt der unteren Oberfläche der Leitschicht (CG) unter der Absorptionsschicht in Luftkontakt zu bringen, und
d) dann werden auf der Hochebene der Absorptionsschicht Kontakteinrichtungen ausgebildet.

6. Verfahren gemäß Anspruch 5,
**dadurch gekennzeichnet**,
daß, um die untere Oberfläche der Leitschicht (CG) unter der Absorptionsschicht in Luftkontakt zu bringen, ein Loch (4) in dem Substrat (S) bis zur unteren Einschließungsschicht (CIC) hergestellt wird, und dann ein separater Eingriff an der unteren Einschließungsschicht (CIC) ausgeführt wird, ohne die Leitschicht (CG) anzugreifen.

7. Verfahren gemäß Anspruch 5,
**dadurch gekennzeichnet,**
daß, um die untere Oberfläche der Leitschicht (CG) unter der Absorptionsschicht (6) in Lufkontakt zu bringen, die untere Umschließungsschicht (CIC) von der Seite her durch Tiefengravur einer oberflächlichen Substratschicht angegriffen wird.

8. Verfahren gemäß Anspruch 5,
**dadurch gekennzeichnet,**
daß, zur Zeit des Graviervorgangs der Absorptionsschicht (CA), ebenfalls die obere Umschließungsschicht (CSC) in einem bestimmten Bereich (2) vor der Hochebene graviert wird.

## Claims

1. Optoelectronic device with an integrated optical guide and photodetector comprising, on the same semiconductor substrate (S), an optical guide constituted by a first layer called the lower confinement layer (CIC), a second layer called the guide layer (CG), a third layer called the upper confinement layer (CSC), said layers being laterally etched in order to form a guide ribbon (RG) and a mesa-shaped photodetector (PHD) placed above the upper confinement layer (CSC), said photodetector particularly comprising a fourth layer called the absorbent layer (CA) able to absorb radiation from the guide layer (CG) by evanescence through the upper confinement layer (CSC), said device being characterized in that, in the zone located below the photodetector (PHD), at least the lower confinement layer (CIC) is removed, so that the lower surface of the guide layer (CG) is at least partly in contact with the air below the absorbent layer (CA).

2. Device according to claim 1, characterized in that the substrate (S) is hollowed out below the photodetector (PHD) in order to free the guide layer (CG) below said photodetector (PHD).

3. Device according to claim 1, characterized in that the substrate (S) remains below the photodetector (PHD) and an air pocket (6) is formed below the photodetector (PHD) between the guide layer (CG) and the substrate (S).

4. Device according to any one of the claims 1 to 3, characterized in that the upper confinement layer (CSC) is removed by a certain length (2) in front of the photodetector.

5. Process for producing an optoelectronic device with an integrated optical guide and photodetector according to claim 1, characterized in that it comprises the following operations:
a) on a substrate (S) deposition takes place by epitaxy of a lower confinement layer (CIC), a guide layer (CG), an upper confinement layer (CSC) and an absorbent layer (CA),
b) lateral etching then takes place of the confinement layers and the guide layer to form a guide ribbon (RG) and the absorbent layer (CA) is etched to give it the shape of a mesa,
c) local removal then takes place of the lower confinement layer (CIC) below at least one portion of the mesa (4, 6) in order to bring at least one portion of the lower surface of the guide layer (CG) below the absorbent layer into contact with the air,
d) finally on the absorbent layer mesa contact means are formed.

6. Process according to claim 5, characterized in that, in order to bring the lower surface of the guide layer (CG) into contact with the air below the absorbent layer, a hole (4) is formed in the substrate (S) up to the lower confinement layer (CIC), which is followed by selective etching of the lower confinement layer (CIC) without etching the guide layer (CG).

7. Process according to claim 5, characterized in that, to bring the lower surface of the guide layer (CG) into contact with the air below the absorbent layer (6), the lower confinement layer (CIC) is laterally etched by subetching a surface layer of the substrate.

8. Process according to claim 5, characterized in that, during the etching of the absorbent layer (CA), etching also takes place of the upper confinement layer (CSC) in front of the mesa and over a certain interval (2).
